# EUROPÄISCHE PATENTANMELDUNG

(11) **EP 3 627 544 A1**
(43) Veröffentlichungstag der Anmeldung: **25.03.2020**
(21) Anmeldenummer: 18195625.1
(22) Anmeldetag: 20.09.2018
(51) Int. Cl.: H01L 23/00, H01L 25/07

(54) **SUBSTRATANORDNUNG ZUM VERBINDEN MIT ZUMINDEST EINEM ELEKTRONIKBAUTEIL UND VERFAHREN ZUM HERSTELLEN EINER SUBSTRATANORDNUNG**

(71) Anmelder: Heraeus Deutschland GmbH & Co. KG, 63450 Hanau (DE)
(72) Erfinder: DIETRICH, Peter, 63450 Hanau (DE); HINRICH, Andreas, 63450 Hanau (DE)
(74) Vertreter: Heraeus IP

(57) **Zusammenfassung**

Eine Substratanordnung zum Verbinden mit zumindest einer Kontaktoberfläche eines Elektronikbauteils, aufweisend zumindest ein Substrat mit einer ersten Seite und einer zweiten Seite, wobei auf der ersten Seite des Substrats zumindest bereichsweise zumindest eine Erhebung in der im Wesentlichen ebenen Oberfläche der ersten Seite zum Verbinden mit der Kontaktoberfläche des Elektronikbauteils ausgebildet ist. Auch betrifft die vorliegende Erfindung ein Verfahren zum Herstellen einer Substratanordnung und ein Verfahren zum Verbinden mindestens eines Elektronikbauteils mit einer Substratanordnung.

## Beschreibung

Die vorliegende Erfindung betrifft eine Substratanordnung zum Verbinden mit zumindest einem Elektronikbauteil. Weiterhin betrifft die vorliegende Erfindung ein Verfahren zum Herstellen einer Substratanordnung zum Verbinden mit zumindest einem Elektronikbauteil.

In der Leistungselektronik gibt es schon seit einiger Zeit den Trend zur Verwendung von Halbleitern mit einem hohen Bandabstand, wie beispielsweise die Verwendung von SIC-Chips. Bedingt durch die Defekt-Rate im Wafer sind diese Leistungshalbleiter in ihrer maximalen Größe beschränkt, um hierdurch eine zufriedenstellende Produktionsausbeute sicher zu stellen. Damit eine vergleichbare Leistung wie mit konventionellen Anordnungen erreicht werden kann, werden mehrere SIC-Chips parallel eingesetzt. Die oberseitige Kontaktierung der SIC-Chips gestaltet sich wegen ihrer Bauformen wesentlich schwieriger und aufwändiger als die Kontaktierung von konventionellen Anordnungen, da die Kontaktoberflächen viel kleiner sind und sich aus vielen kleinen Flächen zusammensetzen. Daher ist eine Verwendung von bestehenden Modul-Designs in vielen Fällen nicht möglich.

Um die Kontaktierung zu verbessern schlägt beispielsweise die DE 10 2014 117 245 A1 einen Adapter vor, der auf einer Kontaktoberfläche eines Elektronikbauteils, wie beispielsweise einem Leistungshalbleiter-Chip angeordnet werden kann. Allerdings ist aus dem Stand der Technik keine zufriedenstellende Lösung bekannt zur gemeinsamen Kontaktierung von mehreren Chip-Oberseiten, um somit eine gemeinsame Kontaktoberfläche herzustellen.

Aufgabe der vorliegenden Erfindung ist es daher, eine verbesserte Substratanordnung und ein Verfahren zum Herstellen einer verbesserten Substratanordnung bereitzustellen, die eine Verwendung marktüblicher Leistungshalbleiter und Modul-Designs ermöglicht, sowie eine Kontaktierung der Kontaktoberflächen von Elektronikbauteilen gemäß den bekannten Verfahren erlaubt.

Diese Aufgabe wird erfindungsgemäß durch eine Substratanordnung gemäß des Gegenstands des Patentanspruchs 1 gelöst.

Die erfindungsgemäße Substratanordnung zur Verbindung mit zumindest einem Elektronikbauteil, weist hierfür auf:
zumindest ein Substrat mit einer ersten Seite und einer zweiten Seite, wobei auf der ersten Seite des Substrats zumindest bereichsweise zumindest eine Erhebung in der im Wesentlichen ebenen Oberfläche der ersten Seite zum Verbinden mit der Kontaktoberfläche des Elektronikbauteils ausgebildet ist.

In diesem Zusammenhang kann der Begriff "Elektronikbauteil" verwendet werden, um ein elektronisches, beziehungsweise elektrisches Bauelement, zu bezeichnen. Der Begriff "Elektronikbauteil" kann daher Bauelemente umfassen, die in der Leistungselektronik verwendet werden, wie beispielsweise SIC Chips. In einem Beispiel kann die erfindungsgemäße Substratanordnung mit dem Elektronikbauteil verwendet werden. In einem weiteren Beispiel der Erfindung kann die erfindungsgemäße Substratanordnung das Elektronikbauteil umfassen. Der Begriff "Kontaktoberfläche" kann verwendet werden, um einen Bereich oder mehrere Bereiche an dem Elektronikbauteil zu bezeichnen, mit denen elektrisch leitende Verbindungen hergestellt werden können.

Erfindungsgemäß ist auf der ersten Seite des Substrats zumindest bereichsweise zumindest eine Erhebung in der im Wesentlichen ebenen Oberfläche der ersten Seite zum Verbinden mit dem Elektronikbauteil ausgebildet. Der Begriff "Erhebung" kann auch als eine Erhöhung, ein Vorsprung oder als eine Verdickung bezeichnet werden. Beispielsweise kann die Erhebung stufenförmig ausgeprägt sein und durch Abtragen des Materials aus der Oberfläche des Substrats gebildet werden. Alternativ kann die Erhebung auch ein Abstandshalter, beispielsweise ein DTS Spacer sein, der auf der Oberfläche des Substrats angeordnet ist. Die Erhebung kann in Beispielen der Erfindung eine Erhebung von weniger als 0,15 mm sein.

In einem Beispiel kann das Substrat der ersten Seite zumindest bereichsweise zumindest zwei oder mehrere Erhebungen in der im Wesentlichen ebenen Oberfläche der ersten Seite zum Verbinden mit mindestens zwei oder mehreren Kontaktoberflächen von zwei oder mehreren Elektronikbauteilen aufweisen. Auf den zwei oder mehreren Erhebungen kann jeweils zumindest abschnittsweise eine Kontaktierungsmaterial-Schicht aufgebracht sein. Der Begriff "Kontaktierungsmaterial" kann dazu verwendet werden, um einen Bereich zu bezeichnen, mit dem eine elektrisch leitende Verbindung hergestellt werden kann.

Die Erfindung ermöglicht es die Kontaktoberflächen mehrerer Leistungshalbleiter zu verbinden und damit eine gemeinsame Kontaktoberfläche zu erzeugen, welche mit den aus dem Stand der Technik bekannten Verfahren, beispielsweise durch Drahtbonden mit Kupferdraht, kontaktierbar ist. Weiter vorteilhaft wird durch die Erhebung die Randisolation der kontaktierten Elektronikbauteile nicht überbrückt. Auch wird durch den Einsatz einer erfindungsgemäßen Substratanordnung wegen der Vergrößerung des Kontaktbereichs eine höhere Stromtragfähigkeit, sowie eine bessere Wärmeabführung gewährleistet und dadurch eine höhere Zuverlässigkeit erreicht.

In einem Beispiel ist die Erhebung durch zumindest einem teilweisen Materialabtrag, bevorzugt mittels einem elektrochemischen Abtragen oder einem mechanischen Abtragen, in einem Bereich zumindest teilweise die Erhebung umgebend ausgeformt.

Beispielsweise kann die Erhebung, abhängig von der gewünschten Verwendung, durch Ätzen, Fräsen, mit einem Laser, durch Umformen wie beispielsweise durch Tiefziehen oder Biegen hergestellt werden. Die Erhebung kann mindestens 50% der Höhe des darum angeordneten Substrats betragen und sich über mindestens 10% der Oberfläche des Substrats erstrecken. Die dem Substrat abgewandte Oberfläche der Erhebung kann eine Geometrie aufweisen, die der Kontaktoberfläche des Elektronikbauteils entspricht.

Alternativ hierzu, wird die Erhebung in einem weiteren Beispiel mittels zumindest eines Abstandshalters gebildet, bevorzugt umfassend das gleiche Material wie das Substrat, und/oder der Abstandshalter ist ringförmig, rechteckig, quadratisch, oder polygonal ausgebildet.

Vorteilhaft kann somit ohne eine mechanische oder chemische Bearbeitung des Substrats die Erhebung gebildet werden und hierdurch unterschiedliche Designs schnell und kostengünstig realisiert werden.

In einem weiteren Beispiel sind auf der im Wesentlichen ebenen Oberfläche der ersten Seite des Substrats mindestens zwei Erhebungen zur Verbindung mit zumindest jeweils einer Kontaktoberfläche von zumindest jeweils einem Elektronikbauteil ausgebildet.

Vorteilhaft können hierdurch Kontaktoberflächen an mehreren unterschiedlichen Elektronikbauteilen, die benachbart angeordnet sind, miteinander verbunden werden und eine gemeinsame Kontaktoberfläche geschaffen werden.

In noch einem Beispiel weist das Substrat und/oder die Erhebung zumindest eine Entlastungsstruktur auf um Verformungen des Substrats bei dem Verbinden des Substrats mit dem Elektronikbauteil zu reduzieren.

Als "Entlastungsstruktur" kann eine Ausnehmung oder Öffnung in dem Material des Substrats oder der Erhebung verstanden werden. Vorteilhaft kann durch das Einbringen einer Entlastungsstruktur die Anbindung an die zumindest eine Kontaktoberfläche verbessert werden und dadurch kann eine noch höhere Zuverlässigkeit der Baugruppe erreicht werden.

In einem Beispiel weist die Entlastungstruktur zumindest eine Öffnung oder Ausnehmung, bevorzugt eine schlitzförmige, wellenförmige, und/oder mäanderfömige Öffnung oder Ausnehmung auf, und/oder eine Vielzahl und/oder Kombinationen von derartigen Öffnungen oder Ausnehmungen.

In einem weiteren Beispiel ist zumindest abschnittsweise auf der Erhebung eine Kontaktierungsmaterial-Schicht aufgebracht.

Bei dem Kontaktierungsmaterial kann es sich beispielsweise um ein sinterbares Material bzw. um ein Sintermaterial handeln. Das Kontaktierungsmaterial kann eine Sinterpaste und/oder eine Sinterfolie sein, wobei das Sintermaterial und/oder die Sinterpaste und/oder die Sinterfolie beispielsweise Silber und/oder eine Silberverbindung enthalten kann. Alternativ kann das Kontaktierungsmaterial ein Lot und/oder ein Leitkleber sein. Das Aufbringen des Kontaktierungsmaterials kann durch Aufdrucken, insbesondere Siebdrucken und/oder Schablonendrucken, und/oder Rakeln und/oder Sprayen und/oder Jetten ausgeführt werden bzw. erfolgen.

In noch einem Beispiel ist auf einer dem Substrat abgewandten Seite der Kontaktierungsmaterial-Schicht zumindest abschnittsweise ein Vorfixiermittel aufgebracht, und das Kontaktierungsmaterial der Kontaktierungsmaterial-Schicht umfasst Sinterhilfsmittel und Metallpartikel, insbesondere Silberpartikel oder Kupferpartikel, und/oder das Vorfixiermittel umfasst das gleiche Sinterhilfsmittel.

Das Vorfixiermittel dient lediglich zur Vorfixierung bzw. zu einem vorübergehenden Anheften des Substrates an dem Elektronikbauteil oder des Elektronikbauteils an dem Substrat. Aufgrund des Vorfixierens bzw. Anheftens wird eine ausreichende Transportfähigkeit des Bauteils vom Ort des Bestückens zum Ort des Sinterns hervorgerufen. Das Vorfixiermittel ist ein temporäres Fixiermittel. Mit anderen Worten ist das Vorfixiermittel ein Fixiermittel, das eine vorübergehende Fixierung einer Substratanordnung bzw. eines Substrates mit einem Elektronikbauteil ermöglicht.

In einem Beispiel umfasst das Substrat ein Metallblech oder ein Metallbandabschnitt, insbesondere ein Kupferblech oder ein Kupferbandabschnitt, oder ist ein Leadframe oder ein DCB-, PCB-, AMB-, TFCB-, oder TPC-Substrat.

In einem weiteren Beispiel ist das Substrat auf mindestens einer Seite, insbesondere mit Material, das Gold (Au) oder Nickel-Gold (NiAu) oder Silber (Ag) oder Nickel-Silber (NiAg) oder Nickel-Palladium-Gold (NiPdAu) umfasst, beschichtet, insbesondere galvanisiert oder chemisch abgeschieden.

In noch einem Beispiel umfasst die Substratanordnung einen Träger, der insbesondere als Trägerfolie ausgebildet ist, wobei der Träger mit der Kontaktierungsmaterial-Schicht und/oder dem Vorfixiermittel zumindest haftverbunden ist.

Der Träger dient dazu, dass die Substratanordnung von einer ersten Produktionsstätte zu einer weiteren Produktionsstätte bzw. von einer ersten Fertigungsvorrichtung zu einer weiteren Fertigungsvorrichtung transportiert werden kann. Bei dem Träger kann es sich beispielsweise um eine Trägerfolie, insbesondere um eine Trägerfolie mit geringer Adhäsionskraft, handeln. Des Weiteren ist es möglich, zum Herstellen eines Trägers einen Wafer-Frame mit UV-Tape zu bespannen. Das mit einer Kontaktierungsmaterial-Schicht und dem Vorfixiermittel versehene Substrat kann auf dieses UV-Tape geklebt werden.

Die Erfindung schlägt auch ein Verfahren vor zum Herstellen einer Substratanordnung zum Verbinden mit zumindest einer Kontaktoberfläche eines Elektronikbauteils, umfassend die Schritte:
Bereitstellen zumindest ein Substrat mit einer ersten Seite und einer zweiten Seite; und
Ausbilden auf der ersten Seite des Substrats zumindest bereichsweise zumindest eine Erhebung in der im Wesentlichen ebenen Oberfläche der ersten Seite zum Verbinden der Kontaktoberfläche des Elektronikbauteils.

Weiterhin schlägt die Erfindung ein vor zum Verbinden mindestens eines Elektronikbauteils mit einer erfindungsgemäßen Substratanordnung und/oder mit einer Substratanordnung, die nach dem erfindungsgemäßen Verfahren hergestellt ist, umfassend die Schritte:
Positionieren der Substratanordnung und einer Kontaktoberfläche des Elektronikbauteils zueinander derart, dass eine erste Seite des Substrats mit einer Erhebung dem Elektronikbauteil zugewandt angeordnet ist; und
Verbinden der Substratanordnung mit der Kontaktoberfläche des Elektronikbauteils.

In einem Beispiel weist das Verfahren weiterhin auf die Schritte:
Positionieren der Substratanordnung und einer Kontaktoberfläche eines mindestens zweiten Elektronikbauteils zueinander derart, dass eine erste Seite des Substrats mit einer zweiten Erhebung dem zweiten Elektronikbauteil zugewandt angeordnet ist; und
Verbinden der Substratanordnung mit der einer Kontaktoberfläche des zweiten Elektronikbauteils.

In einem Beispiel weist das Verfahren weiterhin den Schritt auf:
Lösen des Substrats zusammen mit einer aufgebrachten Kontaktierungsmaterial-Schicht vor dem Positionieren der Substratanordnung und des Elektronikbauteils zueinander, von einem Träger.

In einem weiteren Beispiel weist das Verfahren den Schritt auf:
Verbinden der Substratanordnung mit der Kontaktoberfläche des Elektronikbauteils durch Versintern, Verpressen, Verlöten und/oder Verkleben.

Weitere Merkmale und Vorteile der Erfindung ergeben sich aus der nachfolgenden Beschreibung, in der bevorzugte Ausführungsformen der Erfindung anhand von schematischen Zeichnungen erläutert sind.

Dabei zeigt:
- Figur 1a: eine perspektivische Ansicht auf eine Substratanordnung, Elektronikbauteile und eine Leiterplatte in einem noch nicht montierten Zustand gemäß einer Ausführungsform der Erfindung;
- Figur 1b: eine perspektivische Ansicht auf eine Substratanordnung, Elektronikbauteile und eine Leiterplatte in einem montierten Zustand gemäß der in Figur 1a gezeigten Ausführungsform der Erfindung; und
- Figur 2a - 2d: jeweils eine schematische Draufsicht auf eine Erhebung einer Substratanordnung gemäß weiteren Ausführungsformen der Erfindung.

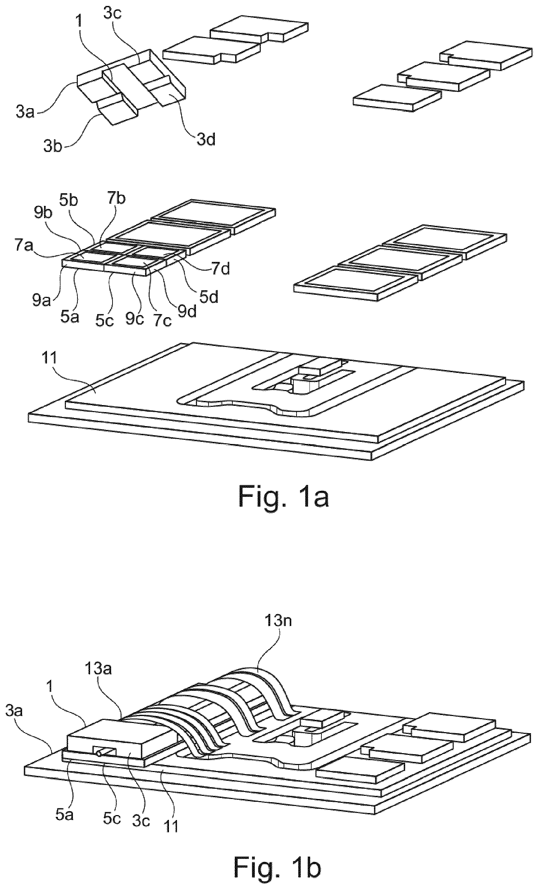

In Figur 1a wird eine schematische Ansicht gezeigt auf eine Substratanordnung 1, Elektronikbauteile 5a - 5d und eine Leiterplatte 11 in einem noch nicht montierten Zustand gemäß einer Ausführungsform der Erfindung.

Die vier in Figur 1a gezeigten Elektronikbauteile 5a - 5d können beispielsweise SIC-Dioden sein, die nebeneinander auf einer Leiterplatte 11 angeordnet sind. Die gezeigten Elektronikbauteile 5a - 5d weisen jeweils eine Kontaktoberfläche 7a - 7d auf, die jeweils von einem Guard-Ring 9a - 9d, zur Erhöhung der Durchbruchspannung, umgeben sind. Die Kontaktoberflächen 7a - 7d bilden jeweils einen ersten Anschluss der Elektronikbauteile 5a - 5d und die gegenüberliegende Seite der Elektronikbauteile 5a - 5d bilden den zweiten Anschluss. In der in Figur 1a gezeigten Ausführungsform sind die vier Elektronikbauteile 5a - 5d in einem Quadrat angeordnet und werden mit ihren zweiten Anschlüssen auf einer Leiterplatte 11 befestigt.

Die oberhalb der Elektronikbauteile 5a - 5d in Figur 1a gezeigte Substratanordnung 1 zum Verbinden mit den Kontaktoberflächen 7a - 7d der Elektronikbauteile 5a - 5d hat vier Erhebungen 3a - 3d in der im Wesentlichen ebenen Oberfläche der ersten Seite des Substrats der Substratanordnung 1. Der Fachmann weiß, dass die Kontaktoberflächen 7a - 7d abhängig von den verwendeten Elektronikbauteilen 5a - 5d eine größere oder kleinere Fläche haben können, die auf unterschiedlichen Bereichen der Elektronikbauteile 5a - 5d angeordnet sein können und abhängig von der geplanten Anwendung eine unterschiedliche Geometrie haben können. In Figur 1a werden die Erhebungen 3a - 3d als quadratische Erhebungen gezeigt. In nicht gezeigten Ausführungsformen, können die Erhebungen 3a - 3d auch kreisförmig, oval, rechteckig, vieleckig, oder durch eine Kombination aus den zuvor genannten Geometrien ausgebildet sein. Die jeweiligen Erhebungen auf dem Substratadapter können eine entsprechende komplementäre Geometrie haben und Erhebungen mit einer Höhe von geringer als 0,15 mm sein. Auf den Erhebungen kann eine Kontaktierungsmaterial-Schicht aufgetragen sein, um die Substratanordnung 1 mit den Elektronikbauteilen 5a - 5d verbinden zu können. Hierfür kann das Kontaktierungsmaterial der Kontaktierungsmaterial-Schicht Sinterhilfsmittel und Metallpartikel, insbesondere Silberpartikel oder Kupferpartikel, umfassen.

Weiterhin werden in Figur 1a gegenüber und neben der Substratanordnung 1 und den Elektronikbauteilen 5a - 5d aus dem Stand der Technik bekannte Elektronikbauteile und Substratanordnungen gezeigt. Hier wird jeweils eine Substratanordnung auf einer Kontaktfläche eines Elektronikbauteils angeordnet. Die aus dem Stand der Technik bekannten Substratanordnungen weisen keine Erhebungen auf.

Figur 1b zeigt eine perspektivische Ansicht auf eine Substratanordnung 1 gemäß der in Figur 1a gezeigten Ausführungsform der Erfindung, Elektronikbauteile 5a, 5c und eine Leiterplatte 11 in einem montierten Zustand. In Figur 1b sind die Erhöhungen 3a, 3c der Substratanordnung 1 mit den Elektronikbauteilen 5a, 5c verbunden. Wie es in der Figur 1b gezeigt ist, sind die oberseitigen Kontakte der Elektronikbauteile 5a, 5c mit den Erhebungen 3a, 3c versintert, verlötet und/oder verklebt und die zweite Seite des Substrats ist mit einem Bonddraht 13a - 13n, beispielsweise mit einem Kupfer-Bonddraht kontaktiert.

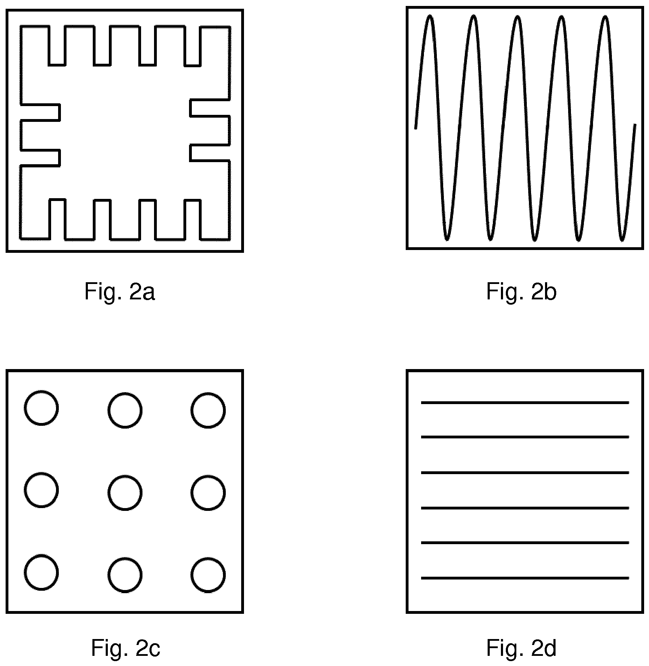

Figur 2a - 2d zeigt jeweils eine schematische Draufsicht auf eine Erhebung einer Substratanordnung gemäß weiteren Ausführungsformen der Erfindung.

Auf dem Substrat und/oder auf den Erhebung(en) können Entlastungsstrukturen eingebracht ein, um Verformungen des Substrats bei dem Verbinden des Substrats mit dem Elektronikbauteil zu reduzieren. Die Entlastungsstrukturen können durch zumindest eine Öffnung oder Ausnehmung gebildet werden. Beispielsweise können die Entlastungsstrukturen eine Durchgangsöffnung in dem Material der Substratanordnung sein oder eine auf eine bestimmte Tiefe begrenzte Ausnehmung in dem Material der Substratanordnung sein. In Figur 2a wird die Entlastungsstruktur als mäanderförmige Öffnung oder Ausnehmung gezeigt, in Figur 2b wellenförmig, in Figur 2c kreisförmig und in Figur 2d schlitzförmig.

Weitere Merkmale und Vorteile der Erfindung ergeben sich aus der nachfolgenden Beschreibung, in der bevorzugte Ausführungsformen der Erfindung anhand von schematischen Zeichnungen erläutert sind.

### Bezugszeichenliste

- 1: Substratanordnung
- 3a - 3d: Erhebung
- 5a - 5d: Elektronikbauteil
- 7a - 7d: Kontaktoberfläche
- 9a - 9d: Guard-Ring
- 11: Leiterplatte
- 13a - 13n: Bonddraht

## Patentansprüche

1. Substratanordnung zum Verbinden mit zumindest einer Kontaktoberfläche eines Elektronikbauteils, aufweisend zumindest ein Substrat mit einer ersten Seite und einer zweiten Seite, wobei auf der ersten Seite des Substrats zumindest bereichsweise zumindest eine Erhebung in der im Wesentlichen ebenen Oberfläche der ersten Seite zum Verbinden mit der Kontaktoberfläche des Elektronikbauteils ausgebildet ist.

2. Substratanordnung nach Anspruch 1, wobei die Erhebung durch zumindest einem teilweisen Materialabtrag, bevorzugt mittels einem elektrochemischen Abtragen oder einem mechanischen Abtragen, in einem Bereich zumindest teilweise die Erhebung umgebend ausgebildet ist, oder
wobei die Erhebung mittels zumindest eines Abstandshalters, bevorzugt umfassend das gleiche Material wie das Substrat, ausgebildet ist, und/oder wobei der Abstandshalter ringförmig, rechteckig, quadratisch, oder polygonal ausgebildet ist.

3. Substratanordnung nach Anspruch 1 oder 2, wobei auf der im Wesentlichen ebenen Oberfläche der ersten Seite des Substrats mindestens zwei Erhebungen zur Verbindung mit zumindest jeweils einer Kontaktoberfläche von zumindest jeweils einem Elektronikbauteil ausgebildet sind.

4. Substratanordnung nach einem der vorangehenden Ansprüche, wobei das Substrat und/oder die Erhebung zumindest eine Entlastungsstruktur aufweist/aufweisen um Verformungen des Substrats bei dem Verbinden des Substrats mit dem Elektronikbauteil zu reduzieren.

5. Substratanordnung nach Anspruch 4, wobei die Entlastungstruktur zumindest eine Öffnung oder Ausnehmung, bevorzugt eine schlitzförmige, wellenförmige, und/oder mäanderfömige Öffnung oder Ausnehmung aufweist, und/oder eine Vielzahl und/oder Kombinationen von derartigen Öffnungen oder Ausnehmungen aufweist.

6. Substratanordnung nach einem der vorangehenden Ansprüche, wobei zumindest abschnittsweise auf der Erhebung eine Kontaktierungsmaterial-Schicht aufgebracht ist.

7. Substratanordnung nach Anspruch 6, wobei auf einer dem Substrat abgewandten Seite der Kontaktierungsmaterial-Schicht zumindest abschnittsweise ein Vorfixiermittel aufgebracht ist, und wobei das Kontaktierungsmaterial der Kontaktierungsmaterial-Schicht Sinterhilfsmittel und Metallpartikel, insbesondere Silberpartikel oder Kupferpartikel, umfasst, und/oder das Vorfixiermittel das gleiche Sinterhilfsmittel umfasst.

8. Substratanordnung nach einem der vorangehenden Ansprüche,
**dadurch gekennzeichnet, dass**
das Substrat ein Metallblech oder ein Metallbandabschnitt, insbesondere ein Kupferblech oder ein Kupferbandabschnitt, oder ein Leadframe oder ein DCB-, PCB-, AMB-, TFCB-, oder TPC-Substrat ist.

9. Substratanordnung nach einem der vorangehenden Ansprüche,
**dadurch gekennzeichnet, dass**
das Substrat auf mindestens einer Seite, insbesondere mit Material, das Gold (Au) oder Nickel-Gold (NiAu) oder Silber (Ag) oder Nickel-Silber (NiAg) oder Nickel-Palladium-Gold (NiPdAu) umfasst, beschichtet, insbesondere galvanisiert oder chemisch abgeschieden, ist.

10. Substratanordnung nach einem der Ansprüche 6 bis 9,
**gekennzeichnet durch**
einen Träger, der insbesondere als Trägerfolie ausgebildet ist, wobei der Träger mit der Kontaktierungsmaterial-Schicht und/oder dem Vorfixiermittel zumindest haftverbunden ist.

11. Verfahren zum Herstellen einer Substratanordnung zum Verbinden mit zumindest einer Kontaktoberfläche eines Elektronikbauteils, umfassend die Schritte:
Bereitstellen zumindest ein Substrat mit einer ersten Seite und einer zweiten Seite; und
Ausbilden auf der ersten Seite des Substrats zumindest bereichsweise zumindest eine Erhebung in der im Wesentlichen ebenen Oberfläche der ersten Seite zum Verbinden der Kontaktoberfläche des Elektronikbauteils.

12. Verfahren zum Verbinden mindestens eines Elektronikbauteils mit einer Substratanordnung nach einem der Ansprüche 1 bis 10 und/oder mit einer Substratanordnung, die nach einem Verfahren nach Anspruch 11 hergestellt ist, umfassend die Schritte:
Positionieren der Substratanordnung und einer Kontaktoberfläche des Elektronikbauteils zueinander derart, dass eine erste Seite des Substrats mit einer Erhebung dem Elektronikbauteil zugewandt angeordnet ist; und
Verbinden der Substratanordnung mit der Kontaktoberfläche des Elektronikbauteils.

13. Verfahren nach Anspruch 12, weiter aufweisend die Schritte:
Positionieren der Substratanordnung und einer Kontaktoberfläche eines mindestens zweiten Elektronikbauteils zueinander derart, dass eine erste Seite des Substrats mit einer zweiten Erhebung dem zweiten Elektronikbauteil zugewandt angeordnet ist; und
Verbinden der Substratanordnung mit der einer Kontaktoberfläche des zweiten Elektronikbauteils.

14. Verfahren nach einem der Ansprüche 12 oder 13,
**gekennzeichnet durch** den Schritt:
Lösen des Substrats zusammen mit einer aufgebrachten Kontaktierungsmaterial-Schicht vor dem Positionieren der Substratanordnung und des Elektronikbauteils zueinander,
von einem Träger.

15. Verfahren nach einem der Ansprüche 12 bis 14,
**gekennzeichnet durch** den Schritt:
Verbinden der Substratanordnung mit der Kontaktoberfläche des Elektronikbauteils durch Versintern, Verpressen, Verlöten und/oder Verkleben.
